# EUROPEAN PATENT APPLICATION

(11) **EP 4 745 666 A1**
(43) Date of publication of application: **20.05.2026**
(21) Application number: 24213003.7
(22) Date of filing: 14.11.2024
(51) Int. Cl.: G03F 7/00, H01L 21/683

(54) **SUBSTRATE SUPPORT**

(71) Applicant: ASML Netherlands B.V., 5500 AH Veldhoven (NL)
(72) Inventor: VYCHOPEN, Marek, 5500 AH Veldhoven (NL); BOGAART, Erik, Willem, 5500 AH Veldhoven (NL)
(74) Representative: ASML Netherlands B.V.

(57) **Abstract**

A substrate support configured to support a substrate. The substrate support, comprises a main body. The main body has a first side configured to support the substrate, and a second side opposite to the first side. A plurality of grooves is formed in the main body. The plurality of grooves comprises a first groove and a second groove longer than the first groove. The first groove is configured to impede a flow of fluid through the first groove in a first direction and to allow the flow of fluid through the first groove in a second direction, opposing the first direction.

## Description

### FIELD

The present invention relates to a substrate support configured to support a substrate, a system comprising the substrate support, and a method of using the substrate support.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer).

As semiconductor manufacturing processes continue to advance, the dimensions of circuit elements have continually been reduced while the amount of functional elements, such as transistors, per device has been steadily increasing over decades, following a trend commonly referred to as "Moore's law". To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm.

A lithographic apparatus may include an illumination system for providing a projection beam of radiation, and a support structure for supporting a patterning device. The patterning device may serve to impart the projection beam with a pattern in its cross-section. The apparatus may also include a projection system for projecting the patterned beam onto a target portion of a substrate.

In a lithographic apparatus, the substrate to be exposed (which may be referred to as a production substrate) may be held on a substrate support (sometimes referred to as a wafer table). The substrate support may be supported on a stage. The substrate support includes a substrate-facing surface of a main body and a stage-facing surface of the main body opposite the substrate-facing surface. Grooves may be formed in the stage-facing surface of the main body of the substrate support. Fluid flow through the grooves may be used to provide negative pressure, for example such that the grooves act as vacuum channels, which may aid in securing the substrate support to the stage. There may be a plurality of through holes in the grooves extending to the substrate-facing side of the substrate support. The plurality of through holes enable the flow to provide negative pressure to aid in securing the substrate to the substrate support.

It has been found that there can be a problem with uneven pressure distribution across the substrate support. In particular, it has been found that differences in the lengths of grooves may result in uneven flow distribution, which can lead to uneven loading of the substrate, which is undesirable.

Uneven load can have a significant impact on the final shape of the substrate and therefore on the quality of final products being made in the system. This uneven loading can also lead to uneven wear of the substrate support over time. It is therefore desirable to overcome these problems by improving uniformity of flow distribution and even negative pressure build up under the substrate.

### SUMMARY

An object of the present invention is to provide a substrate support configured to support a substrate.

In accordance with the present invention, a substrate support configured to support a substrate. The substrate support, comprises a main body. The main body has a first side configured to support the substrate, and a second side opposite to the first side. A plurality of grooves is formed in the main body. The plurality of grooves comprises a first groove and a second groove longer than the first groove. The first groove is configured to impede a flow of fluid through the first groove in a first direction and to allow the flow of fluid through the first groove in a second direction, opposing the first direction.

Also in accordance with the present invention is a lithography system comprising the substrate support.

Also in accordance with the present invention, a metrology system comprising the substrate support system.

Also in accordance with the present invention, a method of securing a substrate to a substrate and/or releasing a substrate from the substrate support.

Further embodiments, features and advantages of the present invention, as well as the structure and operation of the various embodiments features and advantages of the present invention, as well as the structure and operation of the various embodiments of the present invention, are described in detail below with reference to the accompanying drawings.

### BRIEF DESCRIPTION OF THE DRAWINGS

Embodiments of the invention will now be described by way of example only, with reference to the accompanying schematic drawings in which corresponding reference symbols indicate corresponding parts, and in which:
Figure 1 schematically depicts an overview of a lithographic apparatus;
Figure 2 depicts a plan view of a substrate support;
Figure 3 depicts a cross-sectional view of the substrate support of Figure 2;
Figure 4 depicts a view of the second side of a substrate support including a plurality of grooves;
Figure 5 depicts a view of the second side of a substrate support including a plurality of grooves, wherein the first groove includes a flow disruptor;
Figure 6A-E depicts examples of different ways to position the flow disruptor;
Figure 7A-B depicts a view of grooves including through holes having corresponding flow disruptors;
Figure 8A-B depicts a flow disruptor comprising a subsidiary channel, with fluid flowing in the first direction and with fluid flowing in the, opposing, second direction;
Figure 9A-B depicts a flow disruptor comprising a notch with fluid flowing in the first direction and with fluid flowing in the, opposing, second direction;
Figure 10 depicts a groove having a plurality of notches;
Figure 11 depicts a partial view of the grooves of a substrate support comprising a plurality of flow disruptors.

The features shown in the figures are not necessarily to scale, and the size and/or arrangement depicted is not limiting. It will be understood that the figures include optional features which may not be essential to the invention. Furthermore, not all of the features of the substrate support are depicted in each of the figures, and the figures may only show some of the components relevant for describing a particular feature.

### DETAILED DESCRIPTION

In the present document, the terms "radiation" and "beam" are used to encompass all types of electromagnetic radiation, including ultraviolet radiation (e.g. with a wavelength of 436, 405, 365, 248, 193, 157, 126 or 13.5 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

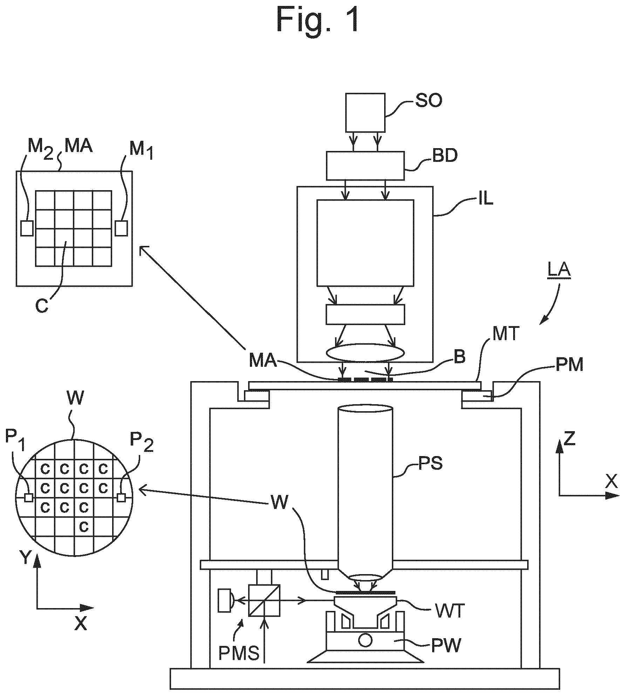

Figure 1 schematically depicts a lithographic apparatus LA. The lithographic apparatus includes an illumination system (also referred to as illuminator) IL configured to condition a radiation beam B (e.g., EUV radiation or DUV radiation), a mask support (e.g., a mask table) MT constructed to support a patterning device (e.g., a mask) MA and connected to a first positioner PM configured to accurately position the patterning device MA in accordance with certain parameters, a substrate table (e.g., a support table or a substrate support) WT constructed to hold a substrate (e.g., a resist coated wafer) W and connected to a second positioner PW configured to accurately position the substrate table WT in accordance with certain parameters, and a projection system (e.g., a refractive projection lens system) PS configured to project a pattern imparted to the radiation beam B by patterning device MA onto a target portion C (e.g., comprising one or more dies) of the substrate W. The substrate table WT may optionally comprise a substrate support (not shown in Figure 1) constructed to hold the substrate W.

In operation, the illumination system IL receives the radiation beam B from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus may be of a type wherein at least a portion of the substrate W may be covered by an immersion liquid having a relatively high refractive index, e.g., water, so as to fill an immersion space between the projection system PS and the substrate W - which is also referred to as immersion lithography. More information on immersion techniques is given in US 6,952,253, which is incorporated herein by reference.

The lithographic apparatus may be of a type having two or more substrate tables WT (also named "dual stage"). In such "multiple stage" machine, the substrate tables WT may be used in parallel, and/or steps in preparation of a subsequent exposure of the substrate W may be carried out on the substrate W located on one of the substrate table WT while another substrate W on the other substrate table WT is being used for exposing a pattern on the other substrate W.

In addition to the substrate table WT, the lithographic apparatus may comprise a measurement stage (not depicted in Figure 1). The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate table WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system PMS, the substrate table WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

In this specification, a Cartesian coordinate system is used. The Cartesian coordinate system has three axis, i.e., an x-axis, a y-axis and a z-axis. Each of the three axes is orthogonal to the other two axes. A rotation around the x-axis is referred to as an Rx-rotation. A rotation around the y-axis is referred to as an Ry-rotation. A rotation around about the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

In a lithographic apparatus it is necessary to position with great accuracy the upper surface of a substrate to be exposed in the plane of best focus of the aerial image of the pattern projected by the projection system. To achieve this, the substrate can be held on a substrate support. The surface of the substrate support that supports the substrate can be provided with a plurality of burls whose distal ends can be coplanar in a nominal support plane. The burls, though numerous, may be small in cross-sectional area parallel to the support plane so that the total cross-sectional area of their distal ends is a few percent, e.g. less than 5%, of the surface area of the substrate. The gas pressure in the space between the substrate support and the substrate may be reduced relative to the pressure above the substrate to create a force clamping the substrate to the substrate support.

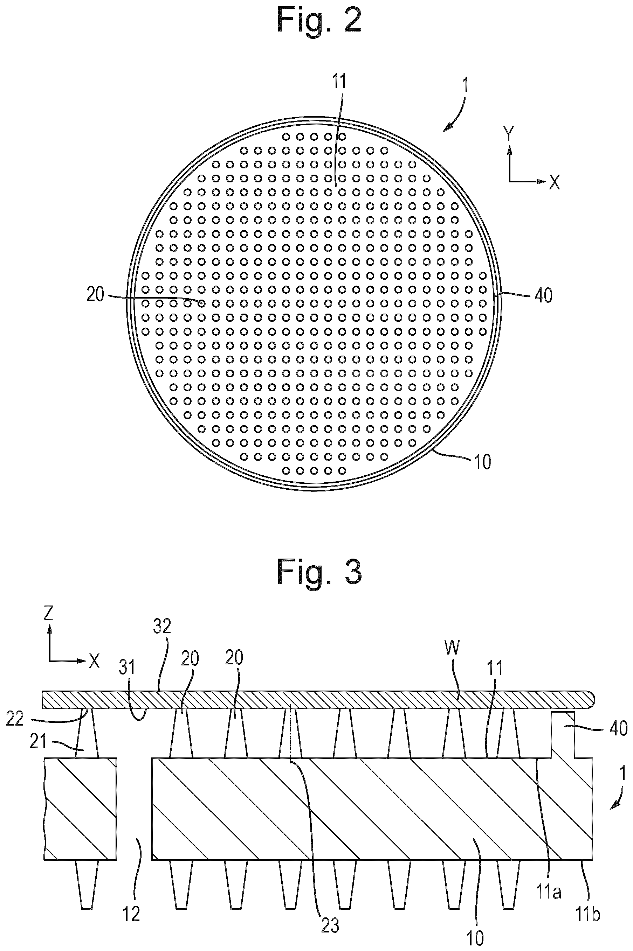

A plan view of a substrate support 1 is shown in Figure 2. A partial cross section of the substrate support 1 is depicted in Figure 3. The substrate support 1 may be a separate component of or integral with the substrate table WT shown in Figure 1. The substrate support 1 may comprise a main body 10 having an upper surface 11. The main body 10 may form a substantial portion of the substrate support 1. The upper surface 11 may be a top surface of the main body 10 when positioned as shown in Figure 3. That is, the upper surface 11 may be top surface in the Z-direction (the vertical direction). The upper surface 11 may be a surface of a first side 11a, i.e., a substrate-facing surface.

The substrate support 1 may comprise a plurality of burls (or protrusions) 20 connected to, and protruding from, the upper surface 11 of the main body 10. Optionally, the substrate support 1 may comprise a plurality of burls (or protrusions) 20 connected to, and protruding from, the lower surface (opposite the upper surface 11) of the main body 10. The plurality of burls 20 may have proximal ends 21, which are situated near the main body 10 when in position, and distal ends 22. The distal ends 22 may be at opposite ends of the plurality of burls 20 to the proximal ends 21. That is, the distal ends 22 may be situated at an end of the burl 20 away from the main body 10.

The plurality of burls 20 may have a central longitudinal axis 23, with the proximal end 21 at one end of the burl 20 and the distal end 22 at the other end of the burl 20 along the central longitudinal axis 23. Thus, each of the plurality of burls 20 may have a central longitudinal axis 23 from the proximal end 21 to the distal end 22.

The distal ends 22 of the plurality of burls 20 form a support plane for a substrate W. Specifically, the distal ends 22 of the plurality of burls 20 may support a lower surface 31 of the substrate W. An upper surface 32 of the substrate W may be a surface opposite the lower surface 31. The upper surface 32 may be a surface which is configured to receive the radiation beam B.

The support plane may be formed in a substantially flat plane. Consequently, the substrate W can be positioned on the support plane to also be substantially flat, which can reduce errors in the pattern printed onto the substrate W (i.e., defectivity).

As shown in Figure 3, the plurality of burls 20 may be substantially frusto-conical, i.e. a truncated cone, or may be conical in shape. They may instead be substantially cylindrical. A frustoconical burl 20 may be stronger than a cylindrical burl 20 and thus have less likelihood of breaking. Preferably the plurality of burls 20 have the same shape as each other.

The plurality of burls 20 may be connected to the upper surface 11 of the main body 10 in any suitable way. The plurality of burls 20 may be separate components which are attached to the upper surface 11 of the main body 10. Alternatively, the plurality of burls 20 may be integral to the main body 10. In other words, the plurality of burls 20 may be formed as protrusions from the upper surface 11 of the main body 10, i.e. the plurality of burls 20 may be formed as a single part with the main body 10.

The substrate support 1 may be configured to enable fluid to be extracted from between the substrate W supported on the support plane and the upper surface 11. Fluid at the edge of the substrate W may be drawn under the substrate W. As fluid is extracted the pressure beneath the substrate W is reduced relative to pressure above the substrate W, and the edge of the substrate W will lower towards the substrate support 1. The substrate W can be clamped by extracting fluid in the space below the substrate W to provide a reduced relative pressure in the space between the substrate support 1 and the substrate W.

The main body 10 may comprise at least one extraction opening or through hole 12 through which the fluid is extracted. There may be a plurality of extraction openings or through holes 12.

It is beneficial to reduce leakage of fluid into the space between the substrate W and the main body 10 when the substrate W is clamped. Therefore, it may be beneficial to provide a physical boundary positioned near the edge of the substrate support 1. The physical boundary could be formed towards an edge of the main body 10 as shown in Figures 2 and 3. The physical boundary could be formed by a sealing member 40. The sealing member 40 may be a wall type protrusion formed around the edge of the main body 10, for example, around the circumference of the main body 10. The sealing member 40 may be formed to provide a seal between the lower side, e.g., lower surface 31, of the substrate W and the substrate support 1 around the edge of the substrate W. The seal provided by the sealing member 40 need not be a perfect seal but may be a partial seal that reduces but does not eliminate flow of fluid into the space between the substrate support 1 and substrate W.

The sealing member 40 may surround the plurality of burls 20. The sealing member 40 may protrude from the upper surface 11 of the main body 10. The sealing member 40 may be connected to the main body 10 in any way. The sealing member 40 may be integral with the main body 10.

A pressure sensor (not depicted in the drawings) may be used to measure the pressure between the substrate W and the upper surface 11 of the main body 10. Various sensors for measuring the pressure in the space below the substrate W are known. For example, a pressure sensor as disclosed in WO 2017/137129 A1, which is hereby incorporated by reference in its entirety, provides an example of an appropriate pressure sensor which might be used.

A flow rate sensor (not depicted in drawings) may be used to measure the flow rate of the fluid extracted via the extraction opening or through hole 12. Various sensors for measuring the flow rate from the space below the substrate W are known.

For the present invention, the exact arrangement of the substrate support 1 is not particularly limited. For example, the exact arrangement of burls 20, sealing member 40 and extraction openings or through holes 12 in the substrate support 1 is not particularly limited.

The substrate support 1 includes a substrate-facing surface of a main body 10 and a stage-facing surface opposite the substrate-facing surface. The substrate-facing surface may be the upper surface 11 on the first side 11a of the main body 10. The stage-facing surface may be a surface of a second side 11b of the main body 10. Grooves 601, 602 may be formed in the stage-facing surface of the main body 10 of the substrate support 1. Fluid flow through the grooves 601, 602 may be used to provide negative pressure, for example such that the grooves 601, 602 act as vacuum channels, which may aid in securing the substrate support 1 to the stage WT. There may be a plurality of extraction openings or through holes 12 in the grooves 601, 602 extending to the substrate-facing side, e.g., first side 11a, of the substrate support 1. The plurality of through holes enable the flow to provide negative pressure to aid in securing the substrate W to the substrate support 1.

It has been found that there can be a problem with uneven pressure distribution across the substrate support 1. In particular, it has been found that differences in the lengths of grooves 601, 602 may result in uneven flow distribution, which can lead to uneven loading of the substrate W, which is undesirable. For example, a vacuum due to negative pressure under the substrate W may build up faster on the region where shorter grooves 601 are located, compared to a region where longer grooves 602 are located, due to the flow being less widely dispersed.

Uneven load can have a significant impact on the final shape of the substrate W and therefore on the quality of final products being made in the system. One region of substrate W being more rapidly loaded on the substrate support 1 than the other region of the substrate W means that friction forces which differ on the different regions of the substrate W can cause uneven deformation of the substrate W. Deformations of the substrate W may then lead to the end product being of low, or even unacceptably low, quality. This uneven loading can also lead to uneven wear of the substrate support 1 over time. It is therefore desirable to avoid these problems by improving uniformity of flow distribution and even negative pressure build up under the substrate W.

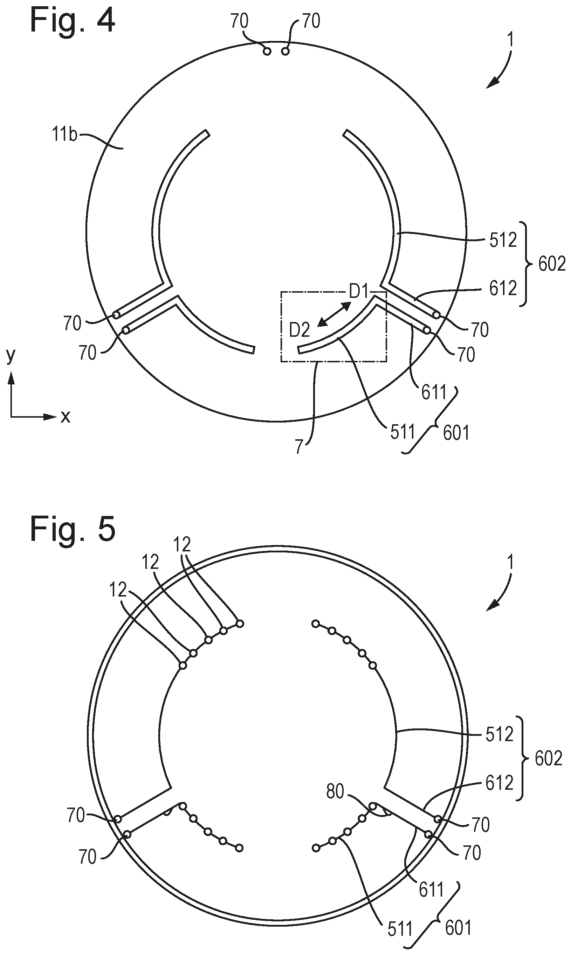

Figure 4 provides a view of second side 11b of a substrate support 1 configured to support a substrate W. The substrate support 1, comprises a main body 10. The main body 10 has a first side 11a configured to support the substrate W, and a second side 11b opposite to the first side 11a. The main body 10 comprises a plurality of grooves 601, 602. The plurality of grooves 601, 602 comprises a first groove 601 and a second groove 602 longer than the first groove 601. The first groove 601 is configured to impede a flow of fluid through the first groove 601 in a first direction. The first groove 601 is configured to allow the flow of fluid through the first groove 601 in a second direction, opposing the first direction. In other words, with this arrangement, the flow of fluid direction through the first groove 601 in the first is impeded more than a flow of fluid in the second direction.

The substrate support 1 is preferably configured such that the flow of fluid through the first groove 601 in the first direction aids in attracting the substrate W to the substrate support 1. With this arrangement, when fluid is flowing in the first direction D1 through the first groove 601, the fluid may flow from the first channel 511 to the first conduit 611. With flow in the first direction D1, fluid is preferably being extracted to create negative pressure in the first and/or second grooves 601, 602, between the substrate W and the substrate support 1. Therefore, because flow of fluid in this direction is impeded, the shorter length of the first groove 601 relative to the second groove 602 may be accommodated for passively. For example, the same amount of negative pressure may be provided in order to provide a flow of fluid through both the first groove 601 and the second groove 602. If there was no means to impede flow through the first groove 601, the first groove 601 could achieve a greater negative pressure more quickly than the longer second groove 602. This may result in undesirable, uneven loading. However, with the arrangement as described above in relation to Figure 4, the first groove 601 is configured to impede flow of fluid in the first direction, such that the uneven loading is reduced or possibly avoided entirely during securing of the substrate W on the substrate support 1.

An arrangement such as that described above with reference to Figure 4 (as well as the arrangements described below in reference to Figures 5 to 11) desirably results in a more evenly distributed flow and therefore improvement in more even loading of the substrate W. This may in turn result in an improvement in final product quality. Furthermore, the substrate support 1 may have better lifetime performance, requiring less maintenance or having a longer working lifespan, due to more wear (e.g., of burls 20) during loading of substrates W on the substrate support 1. This arrangement may be applied to any system or apparatus where a substrate W is secured to a substrate support 1. For example, it may be provided in the lithographic apparatus LA of Figure 1, or in a metrology system, used for substrate W inspection/assessment/processing.

The substrate support 1 may be configured such that the flow of fluid through the first groove 601 in the second direction D2 aids in reducing attraction between the substrate W and the substrate support 1. With this arrangement, when fluid is flowing in the second direction D2 through the first groove 601, the fluid may flow from the first conduit 611 to the first channel 511. With flow in the second direction D2, fluid is preferably being provided to increase pressure in the first and/or second grooves 601, 602, between the substrate W and the substrate support 1. In other words, the first groove 601 may be configured such that it enables a more steady increase of pressure under the substrate W (e.g., back to atmospheric pressure after a vacuum was provided to secure the substrate W to the substrate support 1). In this way, a time to unload the substrate W from the substrate support 1 may not be increased. Whereas, if the flow of fluid through the first groove 601 were impeded in both directions (for example, by decreasing cross-sectional area), the flow in this second direction would be affected, and the unloading of the substrate W may be negatively impacted, by taking more time.

The first and second grooves 601, 602 are optionally provided with a coating configured to promote a fluid flow through the grooves 601, 602. The coating may optionally be a hydrophobic coating, for example a coating comprising fluorine such as polytetrafluoroethylene (PTFE). Alternatively a non-fluorinated coating, for example, polydimethylsiloxane (PDMS), may be used. The coating may comprise any suitable inorganic and/or organosilicon polymer. The polymer may have one or more groups selected from: methyl, ethyl, propyl, phenyl, vinyl, e.g., a Lipocer^{®} coating. In another embodiment the coating may be a coating based on silanized ZrO₂ nanoparticles (Si-ZrO₂).

The first and second grooves 601, 602 may be formed as recessed grooves on the surface on the second side 11b of the substrate support 1. In a preferred arrangement, as shown in Figures, 4 to 6 and 11, the grooves 601, 602 may be open grooves. In other words, the grooves 601, 602 may be uncovered recesses on the surface of the second side 11b of the substrate support 1. In other arrangements, the first and second grooves 601, 602 may be partly, or entirely, covered grooves. In other words, the first and second grooves 601, 602 may be partly, or entirely, embedded within the main body 10. For example, the first and second grooves 601, 602 may have a pipe-like structure.

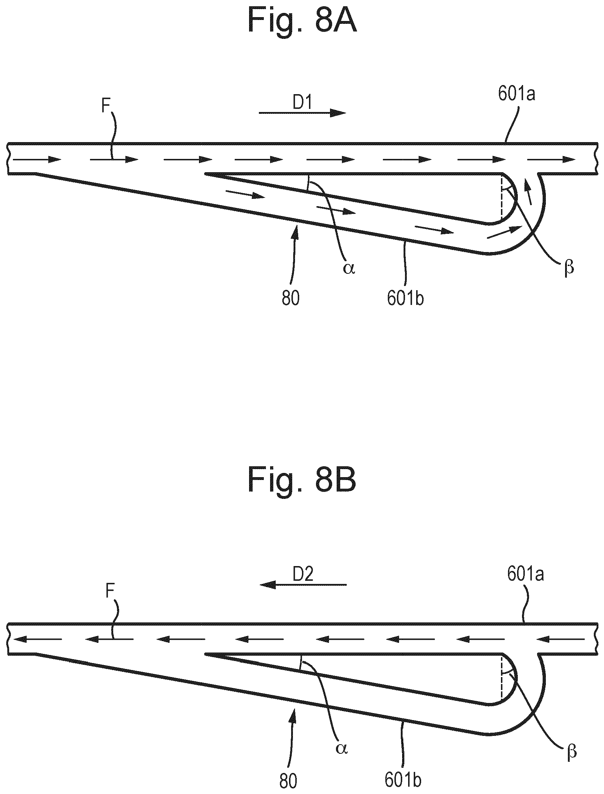

As shown in Figure 5, the first groove 601 may, for example, comprise a flow disruptor 80 configured to impede flow in the first direction and allow flow in the second direction. Any flow disruptor 80 suitable for performing this function may be used. Examples of possible arrangements of flow disruptor 80 are described in detail below with reference to Figures 8A-B and 9A-B and 10.

In the arrangement of Figures 4 to 6 and 11, the plurality of first and second grooves 601, 602 forms a plurality of channels 511, 512 and a plurality of conduits 611, 612. In particular, the first groove 601 forms a first channel 511 and a first conduit 611. The second groove 602 forms a second channel 512 and a second conduit 612. The first conduit 611 is in fluid communication with the first channel 511, and the second conduit 612 is in fluid communication with the second channel 512. The conduits 611, 612 are configured to enable fluid to be extracted from or provided to the corresponding channels 511, 512. The substrate support 1 optionally comprises more than two grooves 601, 602.

In the arrangement of Figures 4 to 6 and 11, the conduits 611, 612 are directly connected to the corresponding channels 511, 512. The channels 511, 512 and the conduits 611, 612 may be continuous grooves. In other words, each channel 511, 512 may be continuously formed with the corresponding conduit 611, 612 and have the same cross-sectional shape and/or size. Alternatively, a channel 511, 512 may have a different cross-sectional shape and/or size than the corresponding conduit 611, 612. The conduits 611, 612 may be disposed radially outward of the channels 511, 512.

In the arrangements shown in Figures 4 to 7 and 11, each conduit 611, 612 of the plurality of conduits are straight and extend in a radial direction. In particular, the first conduit 611 extends in a radial direction and the second conduit 612 extends in a radial direction. In the arrangements of Figures 4 to 7 and 11, the first conduit 611 and the second conduit 612 are approximately parallel with each other. In an alternative arrangement, the first conduit 611 and the second conduit 612 form a non-zero angle. In other words, the first conduit 611 may extend in a different direction than the second conduit 612. In an alternative arrangement, one or more first and second conduits 611, 612 of the plurality of conduits may not be straight and/or may not extend in a radial direction. For example, one or more of the first and second conduits 611, 612 may extend in a non-radial direction. In an alternative arrangement, one or more first and second conduits 611, 612 of the plurality of conduits may follow a curved path between the corresponding channel 511, 512 and a periphery of the substrate support 1. In an alternative arrangement, the first and or second conduits 611, 612 as well as the channels 511, 512 follow a meander-like path that may, for example, be defined by the burl arrangement and distribution.

The substrate support 1 may comprise a plurality of inlets 70, such as those shown in Figures 4 and 5. Each of the inlets 70 is desirably suitable for connection to one or more positive and/or negative pressure sources. The negative pressure source may be a vacuum source configured to create a vacuum within the plurality of grooves when the plurality of first and second grooves 601, 602 are in fluid communication with the vacuum source via one or more of the inlets 70. As shown in Figures 4 and 5, it is desirable that each first and second conduit 611, 612 of the plurality of conduits is in fluid communication with an inlet of the plurality of inlets 70. In this way, the channels 511, 512 may be in fluid communication with the inlets 70 via the respective conduits 611, 612. As shown in Figures 4 and 5, the plurality of inlets 70 optionally comprises one or more inlets 70 which is not in direct fluid communication with a conduit 611, 612. For example, one or more inlets 70 of the plurality of inlets 70 may be configured to provide flow to generate negative pressure on a second side 11b of the substrate support 1. This may be used to aid in securing the substrate support 1 in place, for example on a substrate table WT.

A flow of fluid may be provided through the first and second grooves 601, 602 in the first direction to create a negative pressure between the substrate W and the substrate support 1. For example, a vacuum may be created between the substrate W and the substrate support 1 in order to aid in bringing the substrate W flat against the distal ends 22 of the burls 20 and securely holding the substrate W on the substrate support 1. The flow of fluid may be provided by a negative and/or positive pressure source connected to the inlets 70.

A flow of fluid may be provided through the first and second grooves 601, 602 in the second direction to reduce a negative pressure between the substrate W and the substrate support 1. For example, a negative pressure, which was created between the substrate W and the substrate support 1 in order to aid in securely holding the substrate W on the substrate support 1, may be reduced and an atmospheric pressure may be restored between the substrate W and the substrate support 1. The flow of fluid may be provided by a positive pressure source connected to the inlets 70.

Each of the plurality of inlets 70 are preferably disposed towards the periphery of the substrate support 1, as shown in Figures 4 and 5. In other words, one or more, and desirably all, of the plurality of inlets 70 may be disposed in the outer region into which the conduits 611, 612 extend.

As shown, for example, in Figures 4 to 6 and 11, the channels 511, 512 desirably each have a substantially arc shape. In other words, the first channel 511 and the second channel 512 may extend in a circumferential direction of the substrate support 1. For example, one or more first and second channels 511, 512 of the plurality of channels may have an incomplete circle shape.

In the arrangements of Figures 4 to 6 and 11, the first channel 511 and the second channel 512 are at the same radial distance from a centre of the substrate support 1. In an alternative arrangement, the first channel 511 and the second channel 512 could be arranged at different radial distances from the centre of the substrate support 11. Optionally, the first channel 511 and the second channel 512 may concentric with each other.

As explained above, it may be desirable to disrupt the flow of fluid in the first direction through the first groove 601 because it is shorter than the second groove 602. The first groove 601 may, for example, have a length of up to 80 % of the length of the second groove 602, optionally up to 50%, optionally up to 30%. With an arrangement such as shown in Figures 4 to 6 and 11, the first groove 601 is shorter than the second groove 602 due to the first channel 511 being shorter than the second channel 512. In the arrangements of Figures 4 to 6 and 11, the first conduit 611 is the same length as the second conduit 612. In an alternative arrangement, the first conduit 611 and the second conduit 612 may be different lengths, provided that the total length of the first groove 601 is less than a total length of the second groove 602.

In an alternative arrangement (not shown in the Figures), the first channel 511 may have the same length as the second channel 512, and the first conduit 611 may be shorter than the second conduit 612.

As shown in Figures 5-7B and 11, the first groove 601 may comprise a flow disruptor 80 configured to impede flow in the first direction and allow flow in the second direction. In other words, the flow disruptor 80 may be configured to disrupt and/or impede flow in the first direction more than it disrupts and/or impedes flow in the second direction.

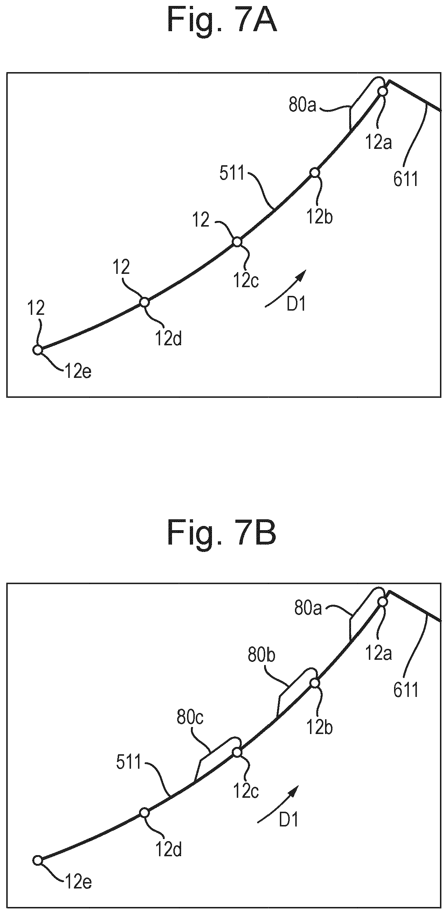

As shown in Figures 5 to 6E, the flow disruptor 80 may be provided along the first conduit 611. In this way, flow of fluid from the first channel 511 and the inlet 70 may be impeded. Alternatively, or additionally, a flow disruptor 80 may be provided along the first channel 511, as shown in Figures 7A and 7B. With either of these arrangements, a negative pressure provided by the flow of fluid to attract a substrate W towards the substrate support 1 may be more even between the shorter first groove 601 and the longer second groove 602 than the negative pressure if the flow disruptor 80 had not been present. In other words, the flow disruptor 80 may be provided to reduce a disparity between fluid flow pressure of the first groove 601 and the second groove 602.

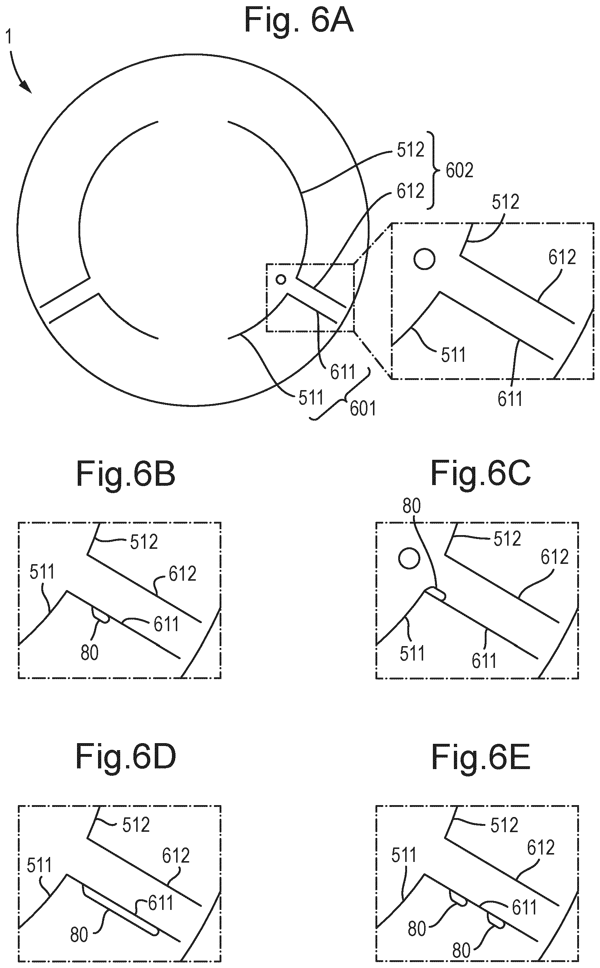

Figure 6A shows a view of second side 11b of a substrate support 1, which may be the same as that described above with respect to Figure 4. Figure 6A shows an enhanced view of a region surrounding the conduits 611, 612. Figures 6B-E each provide the enhanced view of example arrangements wherein at least one flow disruptor 80 is provided along the first conduit 611.

In the example arrangement of Figure 6B, a flow disruptor 80 is provided on a first side of the first conduit 611. The flow disruptor 80 is shown as being disposed along the first conduit 611 at a position closer to a first end of the conduit 611 where the first conduit 611 meets the first channel 511 than to a second end of the first conduit 611 towards a periphery of the substrate support 1. In alternative arrangements, the flow disruptor 80 may be disposed at a midpoint of the first conduit 611, (i.e., centrally between the first end and the second end of the first conduit 611).

In the example arrangement of Figure 6C, a flow disruptor 80 is provided on a second side of the first conduit 611, opposite the first side of the first conduit 611. In Figure 6C, the flow disruptor 80 is provided adjacent to the first channel 511. In this particular example, the flow disruptor 80 is provided at a bend between the first conduit 611, which extends radially, and the first channel 511, which externs circumferentially.

In the example arrangement of Figure 6D, a flow disruptor 80 is provided on the first side of the first conduit 611, similarly to the arrangement of Figure 6B. However, unlike the arrangement of Figure 6B, in the arrangement of Figure 6D the flow disruptor 80 extends over a majority of the length of the first conduit 611. In other words, one end of the flow disruptor 80 is provided close to the first end of the first conduit 611 and the other end of the flow disruptor 80 is provided close to the second end of the first conduit 611. In other words, each end of the flow disruptor 80 may be closer to the respective end of the first conduit 611 than to a centre of the conduit 611 (located at a midpoint between the first end of the conduit 611 and the second end of the first conduit 611).

The first groove 601 may optionally comprise a plurality of flow disruptors 80 disposed at different positions along the first groove 601. In the example arrangement of Figure 6E, there are a plurality of flow disruptors 80 located at different positions along the groove 601. In particular, in this example arrangement there are two flow disruptors 80 and each of the flow disruptors 80 is located along the first conduit 611. In this example, both flow disruptors 80 are located on the first side of the first conduit 611. One of the flow disruptors 80 is closer to the first end of the first conduit 611 than the other of the flow disruptors 80 is to the first end of the first conduit 611.

In an alternative arrangement (not shown in the Figures), there may be a flow disruptor 80 on the first side of the first conduit 611 and a flow disruptor 80 on the second side of the first conduit 611. The flow disruptors 80 may be directly opposite each other, equal distances from the first end of the first conduit 611. Alternatively, one of the flow disruptors 80 may be closer to the first end of the first conduit 611 than the other of the flow disruptors 80 is to the first end of the first conduit 611.

Alternatively, or additionally, to the one or more flow disruptors 80 provided on the first conduit 611, one or more flow disruptors 80 may be provided on the first channel 511.

Figures 7A and 7B depict different arrangements of flow disruptors 80 provided on a substrate support 1 similar to that of Figure 4. In particular, Figures 7A and 7B show a view corresponding to a region 7 of the substrate support 1 including the first channel 511 and the first end of the first conduit 611.

As shown by way of example in Figures 7A and 7B, in a preferred arrangement, the first groove 601 comprises at least one through hole 12. The at least one through hole 12 extends from the second side 11b to the first side 11a of the main body 10 of the substrate support 1. The at least one through hole 12 may be provided in the first channel 511 and/or the second channel 512. The at least one through hole 12 preferably comprises a plurality of through holes 12.

In the arrangements of Figures 7A and 7B, the first channel 511 comprises a plurality of through holes 12a-12e. Furthermore, the second channel 512 (not shown in the Figures) desirably also comprises a plurality of though holes 12. A number of through holes 12 of the second channel 512 may optionally be greater than a number of through holes 12 of the first channel 511, particularly if the second channel 512 is longer than the first channel 511. For example, a spacing between adjacent through holes 12 may be consistent.

In the arrangements of Figures 7A and 7B, the plurality of through holes 12a-12e in the first channel 511 comprises a first through hole 12a. The first through hole 12a is closer to the first conduit 611 than the other through holes 12b-12e of the plurality of through holes 12a-12e in the first channel 511. In the arrangement of Figure 7A, the flow disruptor 80a is connected to the first through hole 12a. In this way, the flow disruptor 12a may cause turbulence and/or re-circulation of flow around the first through hole 12a. This interference with the flow of fluid may increase resistance across the entire cross-section of the first channel 511 in a region around the first through hole 12a, as well as increasing resistance of flow in the first through hole 12a. The first through hole 12a is the through hole 12 of the first channel 511 which is closest to the first conduit 611. The first though hole 12a is therefore also closest (in a path of flow) to the inlet 70 (not shown in the Figures) connected to the first conduit 611. In other words, the first through hole 12a may be the closest through hole 12 of the first groove 601 to a negative pressure source. By providing a flow disruptor 80 at the first through hole 12a, more uniform flow distribution may be achieved between the first channel 511 and the, longer, second channel 512.

In the arrangement of Figure 7A, the first channel 511 comprises a single flow disruptor 80a. However, in other arrangements, the first channel 511 may comprise a plurality of flow disruptors 80a-80c. For example, as shown in Figure 7B, the first channel 511 may comprise a plurality of flow disruptors 80a-80c. Each of the flow disruptors 80a-80c may optionally be connected to a corresponding through hole 12a-12c. Similar to the arrangement of Figure 7A, in the arrangement of Figure 7B, there is a first flow disruptor 80a at the first through hole 12a, closest to the first conduit 611. In a preferred arrangement, the first flow disruptor 80a, at the first through hole 12a, is configured to impede flow of fluid in the first direction more than the flow disruptors 80b-80c disposed at through holes 12b-12c farther from the first conduit 611. It is further preferable that the flow disruptors 80a-c are configured to impede flow of fluid in the first direction less with increasing distance between the respective flow disruptors 80b-80c and the first conduit 611. In other words, a third flow disruptor 80c farthest along the first channel 511 from the first conduit 611 preferably impedes flow in the first direction the least. The first flow disruptor 80a closest, along the first channel 511, to the first conduit 611 preferably impedes flow in the first direction the most. A second flow disruptor 80b provided along the first channel 511, between the first flow disruptor 80a and the third flow disruptor 80c, is preferably configured to impede flow in the first direction more than the third flow disruptor 80c and less than the first flow disruptor 80a. Although Figure 7B shows three flow disruptors 80a-80c, there may be more than three flow disruptors 80a-80c. Optionally each through hole 12 of the first channel 511 may be associated with a corresponding flow disruptor 80.

As explained above, each of the one or more flow disruptors 80 is configured to impede flow in the first direction more than it impedes flow in the second direction. In some arrangements, the flow disruptor 80 may be configured to divert a flow of fluid along the first groove 601 such that some fluid flowing through the first groove 601 disrupts the flow of fluid in the first direction.

Figures 8A and 8B provide an example of one arrangement of flow disruptor 80. Figure 8A shows the flow disruptor 80 with flow of fluid in the first direction D1. Figures 8B shows the flow disruptor 80 with flow of fluid in the second direction D2. In this arrangement, the first groove 601 is formed of a main groove 601a and the flow disruptor 80 comprises a subsidiary groove 601b which branches off the main groove 601a and re-joins the main groove 601a.

As shown in Figure 8A, the subsidiary groove 601b is configured such that, when fluid is flowing in the first direction D1, some fluid is diverted into the subsidiary groove 601b. For example, the subsidiary groove 601b may be arranged at a first angle α to the main groove 601a, such that some fluid is diverted into the subsidiary groove 601b when the fluid is flowing in the first direction D1. The fluid which has been diverted into the subsidiary groove 601b re-joins the main groove 601a at a second angle β such that flow of fluid through the main groove 601a in the first direction is impeded. For example, the subsidiary groove 601b may be configured such that fluid which re-joins the main groove 601a from the subsidiary groove 601b creates turbulent flow of fluid in the main groove 601a. Optionally, the subsidiary groove 601b may be configured such that fluid which re-joins the main groove 601a from the subsidiary groove 601b is travelling in a direction which opposes flow in the first direction D1. In other words, the fluid may re-join the main groove 601b at the second angle β such that the fluid is travelling in a direction with a component across (perpendicular to) the flow of fluid in the first direction D1, or slightly opposing the flow of fluid in the first direction D1.

As shown in Figure 8B, the subsidiary groove 601b is also configured such that, when fluid is flowing in the second direction D2, less fluid is diverted through the subsidiary groove 601b than when fluid is flowing in the first direction D1. The fluid that flows through the subsidiary groove 601b re-joins the main groove 601a at the first angle α that promotes smooth flow of fluid through the main groove 601a in the second direction D2. For example, the subsidiary groove 601b may be configured such that fluid which re-joins the main groove 601a from the subsidiary groove 601b is travelling in a direction with a component which does not oppose flow in the second direction D2. In other words, the fluid may re-join the main groove 601b at the first angle α such that the fluid is travelling predominantly in the first direction D1.

As shown in Figures 8A and 8B, the flow disruptor 80 may be arranged such that the first angle α is formed between the main groove 601a and the subsidiary groove 601b at an upstream position in the first direction D1. This first angle α is preferably a relatively shallow angle, for example 45° or less, such that when the fluid is flowing the first direction D1, some fluid is readily directed into the subsidiary groove 601b, and so that when fluid is flowing in the second direction D2, the fluid re-joining the main groove 601a from the subsidiary channel 601b does not significantly impede flow of fluid through the main groove 601a in the second direction D2. The first angle α may be between 5° and 45°, preferably between 10° and 35°, more preferably between 15° and 25°, optionally 20°.

As shown in Figures 8A and 8B, the flow disruptor 80 may be arranged such that the second angle β is formed between the subsidiary groove 601b and the perpendicular to the main groove 601a at a downstream position in the first direction D1. This second angle β is preferably selected such that when the fluid is flowing the second direction D2, fluid is not readily directed into the subsidiary groove 601b, and so that when fluid is flowing in the first direction D1, the fluid re-joining the main groove 601a from the subsidiary channel 601b impedes flow of fluid through the main groove 601a in the first direction D1. The second angle β may be between 5° and 85°, preferably between 15° and 65°, more preferably between 25° and 45°, optionally between 30° and 40°.

The design of the flow disruptor 80 may be selected in order to select how much the flow of fluid in the first direction D1 is impeded. For example, the larger the cross-sectional area of the subsidiary groove 601b, the greater the amount of fluid may be diverted into the subsidiary groove 601b when fluid is flowing in the first direction D1, and thus the greater the level of impedance. Similarly, the shallower the first angle α between the subsidiary groove 601b and the main groove 601a at which fluid enters the subsidiary groove 601b when fluid is flowing in the first direction D1, the more fluid is likely to be directed into the subsidiary groove 601b to disrupt flow of fluid in the first direction D1. Furthermore, the greater the second angle β at which this redirected fluid re-joins the main groove 601a, the more it may oppose the flow in the first direction D1. Therefore, one or more of the cross-sectional area, the first angle α and/or the second angle β may be adjusted in order to achieve a desired level of impedance of the flow of fluid in the first direction D1.

Although Figures 8A-8B depict the subsidiary groove 601b as having sharp corners, the edges of the subsidiary groove 601b, and/or between the subsidiary groove 601b and the main groove 601a, may be provided with chamfers to minimize flow disturbance in the second direction D2.

As shown in Figures 7A-7B, the flow disruptors 80a-80c may each comprise subsidiary grooves 601b as described above in reference to Figures 8A-8B. In a preferred arrangement, the subsidiary groove 601b may be arranged to re-join the main groove 601a at a location of the through hole 12a-c, with the fluid flowing in the first direction D1. In other words, the flow disruptor 80a-80c is preferably arranged to provide disruptive flow into the through hole 12a-c.

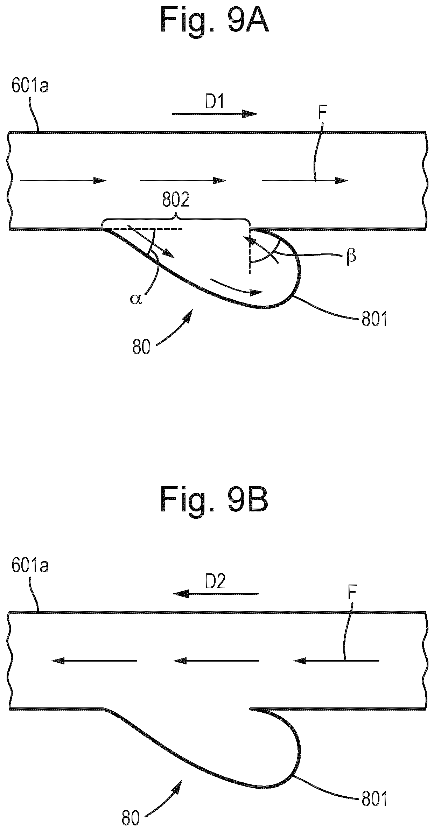

Figures 9A and 9B provide an example of another arrangement of flow disruptor 80. Figure 9A shows the flow disruptor 80 with flow of fluid in the first direction D1. Figures 9B shows the flow disruptor 80 with flow of fluid in the second direction D2. In this arrangement, the first groove 601 is formed of a main groove 601a and the flow disruptor 80 comprises a notch 801 in the main groove 601a. In other words, the flow disrupter 80 is formed of a notch 801, or bulge, in the main groove 601.

As shown in Figure 9A, the notch 801 is configured such that, when fluid is flowing in the first direction D1, some fluid is diverted into notch 801. When fluid is flowing in the first direction D1, fluid that flows into the notch 801 is re-directed at a second angle β that impedes flow of fluid through the main groove 601a in the first direction D1.

As shown in Figure 9B, the notch 801 is configured such that, when fluid is flowing in the second direction D2, less fluid is diverted into the notch 801 than when fluid is flowing in the first direction D1. When fluid is flowing in the second direction D2, fluid that flows into the notch 801 is re-directed at a first angle α that promotes smooth flow of fluid through the main groove 601a in the second direction D2.

As shown in Figures 9A and 9B, the flow disruptor 80 may be arranged such that the first angle α is formed between the main groove 601a and an outer wall of the notch 801 at an upstream position in the first direction D1. This first angle α is preferably a relatively shallow angle, for example 45° or less, such that when the fluid is flowing the first direction D1, some fluid is readily directed into the notch 801, and so that when fluid is flowing in the second direction D2, the fluid re-joining the main groove 601a from the notch 801 does not significantly impede flow of fluid through the main groove 601a in the second direction D2. The first angle α may be between 5° and 45°, preferably between 10° and 35°, more preferably between 15° and 25°, optionally 20°.

As shown in Figures 9A and 9B, the flow disruptor 80 may be arranged such that the second angle β is formed between the outer wall of the notch 801 and the perpendicular to the main groove 601a at a downstream position in the first direction D1. This second angle β is preferably selected such that when the fluid is flowing the second direction D2, fluid is not readily directed into the notch 801, and so that when fluid is flowing in the first direction D1, the fluid re-joining the main groove 601a from the notch 801 impedes flow of fluid through the main groove 601a in the first direction D1. The second angle β may be between 5° and 85°, preferably between 15° and 65°, more preferably between 25° and 45°, optionally between 30° and 40°.

The notch 801 may have a roughly tear-drop shape, with an increasing width downstream in a first direction D1. Furthermore, as shown in Figures 9A and 9B, the notch 801 may be configured to extend downstream in a first direction D1 from an opening 802 between the notch 801 and the main groove 601a.

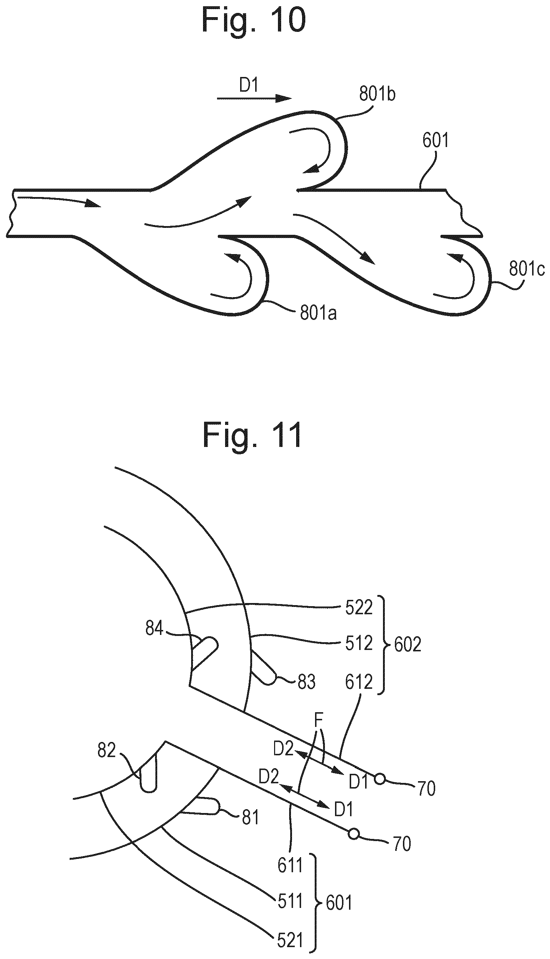

The first groove 601 may comprise a plurality of flow disruptors 80. The plurality of flow disruptors 80 may include a plurality of notches 801a-801c. In the example arrangement of Figure 10, the plurality of notches 801a-801c includes a plurality of notches 801a, 801c on a first side of the first groove 601 and at least one notch 801b on a second side of the first groove 601. One of the at least one notches on the second side of the first groove 601 is disposed between two notches 801a, 801c disposed on the first side of the first groove 601 in the first direction D1. In this way, there may be an interaction of flow through each of the notches 801a-801c which aids in impeding flow of fluid in the first direction D1. This arrangement may be similar to a baffle fishway, or fish stair, without vertical inclination.

In another arrangement (not shown in the Figures), the first groove 601 may include a combination of at least one notch 801 and at least one subsidiary channel 601b.

The second groove 602 may optionally comprise one or more flow disruptors 80. The one or more flow disruptors 80 of the second groove 602 may be configured to impede flow in the first direction D1 and allow flow in the second direction D2. In other words, one or more flow disruptors 80 may be provided to impede flow being used to aid in securing the substrate W to the substrate support 1. Alternatively, the one or more flow disruptors 80 of the second groove 602 may be configured to impede flow in the second direction D2 and allow flow in the first direction D1. In other words, one or more flow disruptors 80 may be provided to impede flow when the substrate W is being removed from the substrate support 1.

The one or more flow disruptors 80 may be provided such that, with flow in a first direction D1 (to secure the substrate W to the substrate support 1), a fluid flow rate through the first groove 601 is less than the fluid flow rate when fluid is flowing in the opposing, second direction D2 (to release the substrate W from the substrate support 1).

The substrate support 1 may optionally include a plurality of flow disruptors 80 configured to provide different flow rates in different grooves and/or in different channels and/or conduits of a groove. One example arrangement is shown in Figure 11 (noting that Figure 11 shows only a partial view, of half of the grooves 601, 602 of the substrate support 1, and the substrate support 1 preferably further comprises a mirror image duplicate of the arrangement of that shown in Figure 11). The arrangement of Figure 11 comprises a first groove 601 comprising a first channel 511 connected to a first conduit 611. The first groove 601 of the arrangement of Figure 11 further comprises a first additional channel 521 in fluid communication with the first conduit 611. Fluid may flow through the first and second grooves 601, 602 in the first direction D1 or the second direction D2. When fluid is flowing in the first direction D1 through the first groove 601, the fluid is flowing from the first channel 511 and the first additional channel 521 to the first conduit 611. In other words, with flow F in the first direction D1, fluid is being extracted through the inlets 70 to create negative pressure in the first and/or second grooves 601, 602, between the substrate W and the substrate support 1. When the flow F is in the second direction D2 through the first groove 601, the fluid is flowing from the first conduit 611 to the first channel 511 and the first additional channel 521. In other words, with the flow F in the second direction D2, fluid is being provided through the inlets 70 to increase pressure in the first and/or second grooves 601, 602, between the substrate W and the substrate support 1.

As shown, for example, in Figure 11, the first additional channel 521 may be concentrically arranged with respect to the first channel 511. The first channel 511 comprises a first flow disruptor 81. The first additional channel 521 comprises a second flow disruptor 82. The first flow disruptor 81 is configured to impede flow in the first direction D1 and allow flow in the second direction D2. The second flow disruptor 82 is configured to impede flow in the second direction D2 and allow flow in the first direction D1. For example, the second flow disruptor 82 may be provided in a reverse orientation compared to the first flow disruptor 81, as shown in Figure 11. In this way, the substrate support 1 is configured to apply a different force on the substrate W via fluid flow through the first channel 511 than the first additional channel 521. For example, to secure a substrate W to the substrate support 1, a negative pressure flow may be provided by applying suction at the inlets 70, creating flow in the first direction D1. The flow in the first direction D1 is impeded in the first channel 511 and is allowed in the first additionally channel 521. Therefore, a flow rate in the first channel 511 in the first direction D1 may be less than a flow rate in the first additional channel 521 due to the first flow disruptor 81and the second flow disruptor 82. To remove the substrate W from the substrate support 1, a positive pressure flow may be provided by applying fluid to the first groove 601 through the inlet 70, creating flow in second direction D2. The flow in the second direction D2 is allowed in the first channel 511 and is impeded in the first additionally channel 521. Therefore, a flow rate in the first channel 511 in the second direction D2 may be greater than a flow rate in the first additional channel 521 due to the first flow disruptor 81 and the second flow disruptor 82. The flow disruptors 81, 82 may therefore be used to passively provide a difference in flow rate between the first channel 511 and the first additional channel 521.

As shown, for example, in Figure 11, a second additional channel 522 may be concentrically arranged with respect to the second channel 512. The second channel 521 comprises a third flow disruptor 83. The second additional channel 522 comprises a fourth flow disruptor 84. The third flow disruptor 83 is configured to impede flow in the first direction D1 and allow flow in the second direction D2. The fourth flow disruptor 84 is configured to impede flow in the second direction D2 and allow flow in the first direction D1. In this way, the substrate support 1 is configured to apply a different force on the substrate W via fluid flow through the second channel 512 than the second additional channel 522. For example, to secure a substrate W to the substrate support 1, a negative pressure flow may be provided by applying suction at the inlets 70, creating flow in the first direction D1. The flow in the first direction D1 is impeded in the second channel 512 and is allowed in the second additionally channel 522. Therefore, a flow rate in the second channel 512 in the first direction D1 may be less than a flow rate in the second additional channel 522 due to the third flow disruptor 83 and the fourth flow disruptor 84. To remove the substrate W from the substrate support 1, a positive pressure flow may be provided by applying fluid to the second groove 602 through the inlet 70, creating flow in second direction D2. The flow in the second direction D2 is allowed in the second channel 512 and is impeded in the second additionally channel 522. Therefore, a flow rate in the second channel 512 in the second direction D2 may be greater than a flow rate in the second additional channel 522 due to the third flow disruptor 83 and the fourth flow disruptor 84. The flow disruptors 83, 84 may therefore be used to passively provide a difference in flow rate between the second channel 512 and the second additional channel 522.

An arrangement such as that of Figure 11 may be desirable when securing the substrate W to the substrate support 1 because a stronger suction force is provided in the first and second additional channels 521, 522 which are closer to a centre of the substrate support 1, and thus a centre of the substrate W, than the suction force provided by the first and second channels 511, 521 towards the periphery of the substrate support, and thus a periphery of the substrate W. Thus, in a passive manner, the substrate W is initially secured as a centre of the substrate W and is gradually secured towards the periphery of the substrate W. To release the substrate W, the fluid is introduced through the inlets 70 to the grooves 601, 602. With the arrangement of Figure 11, the release of the substrate W starts at an outer region due to the allowed flow through the first and second channels 511, 512 in the second direction D2, rather than the more central regions due to the impeded flow through the first and second additional channels 512, 522 in the second direction D2. This sequence of securing the substrate W from the centre to the periphery and releasing the substrate W from the periphery to the centre is particularly advantageous when the substrate W is warped to have a generally bowl shape (with a lowest point towards a centre of the substrate W and raised towards the periphery of the substrate W).

If a substrate W were warped to have a generally umbrella shape (which has a highest point in a centre of the substrate W and lower towards the periphery of the substrate W), it may be desirable to have a reversed sequence. In other words, it may be desirable to have the substrate W secured to the substrate support 1 starting from the periphery before securing the centre, and it may be desirable to remove the substrate W by releasing the centre before releasing the periphery. This may be achieved by providing each flow disruptor 81-84 to operate in the opposite direction to that of Figure 11. In other words, the first flow disruptor 81 and the third flow disruptor 83 may be configured to impede flow in second direction D2 and allow flow in the first direction D1. The second flow disruptor 82 and the fourth flow disruptor 84 may be configured to impede flow in first direction D1 and allow flow in second direction D2.

A substrate support 1 may comprise an arrangement of grooves 601, 602 such as that of Figure 11, configured to secure a substrate W from the centre first and the periphery last. The substrate support 1 may further comprise an arrangement of grooves (not shown in the Figures), configured to secure a substrate W from the periphery first and the centre last. One of the arrangements of grooves 601, 602 may be connected to a first set of inlets 70 and the other arrangement of grooves may be connected to a second set of inlets 70. Therefore, which arrangement of grooves 601, 602 is to be used may be selected by providing fluid flow through either the first set of inlets 70 (e.g., if the substrate W has a bowl shape) or the second set of inlets 70 (e.g., if the substrate W has an umbrella shape).

It should be understood that this concept is not limited to the arrangement shown in Figure 11. For example, a substrate support 1 may comprise a greater number of channels, conduits and/or inlets.

It will also be appreciated that the principles of the present invention can be applied to metrology or lithographic tools and clamping systems that employ electrostatic clamps. In such a case, rather than controlling the flow rate of an evacuation flow, other relevant parameters such as the voltage applied to the electrostatic clamp may be controlled.

Although specific reference may be made in this text to the use of a metrology system in the context of the manufacture of ICs, it should be understood that the metrology system described herein may have other applications, such as in the manufacture of integrated optical systems, guidance and detection patterns for magnetic domain memories, flat-panel displays, liquid-crystal displays (LCDs), thin film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains one or multiple processed layers.

Although specific reference may have been made above to the use of embodiments of the invention in the context of optical lithography, it will be appreciated that the invention may be used in other applications.

While specific embodiments of the invention have been described above, it will be appreciated that the invention may be practiced otherwise than as described.

The descriptions above are intended to be illustrative, not limiting. Thus, it will be apparent to one skilled in the art that modifications may be made to the invention as described without departing from the scope of the claims set out below.

Embodiments include the following numbered clauses:
1. A substrate support configured to support a substrate, comprising a main body having:
   a first side configured to support the substrate; and
   a second side opposite to the first side;
   wherein a plurality of grooves is formed in the main body;
   wherein the plurality of grooves comprises a first groove and a second groove longer than the first groove;
   wherein the first groove is configured to impede a flow of fluid through the first groove in a first direction and to allow the flow of fluid through the first groove in a second direction, opposing the first direction.
2. The substrate support according to clause 1, wherein the plurality of grooves forms a plurality of channels and a plurality of conduits, wherein the conduits are configured to enable fluid to be extracted from or provided to the corresponding channels,
   wherein the first groove comprises a first channel and a first conduit, and the second groove comprises a second channel and a second conduit,
   wherein the first conduit is in fluid communication with the first channel, and the second conduit is in fluid communication with the second channel.
3. The substrate support according to clause 2, wherein the first channel and the second channel each have a substantially arc shape.
4. The substrate support according to clause 3, wherein the first channel and the second channel extend in a circumferential direction of the substrate support.
5. The substrate support according to clause 4, wherein the first channel and the second channel are both disposed at the same radial distance from a centre of the substrate support.
6. The substrate support according to any of clauses 2 to 5, wherein the second channel is longer than the first channel.
7. The substrate support according to any of clauses 2 to 6, wherein the first conduit is the same length as the second conduit.
8. The substrate support according to any preceding clause, wherein the substrate support is configured such that the flow of fluid through the first groove in the first direction aids in attracting the substrate to the substrate support.
9. The substrate support according to clause 8, wherein the substrate support is configured such that the flow of fluid through the first groove in the second direction aids in reducing attraction between the substrate and the substrate support.
10. The substrate support according to any preceding clause, wherein the first groove comprises a flow disruptor configured to impede flow in the first direction and allow flow in the second direction.
11. The substrate support according to clause 10, wherein the first groove comprises a plurality of flow disruptors disposed at different positions along the first groove.
12. The substrate support according to clause 10 or 11, when dependent on clause 2, wherein each of the first channel and the second channel comprises at least one through hole, wherein the at least one through hole extends from the second side to the first side.
13. The substrate support according to clause 12, wherein the at least one through hole comprises a plurality of through holes.
14. The substrate support according to clause 13, wherein the plurality of through holes in the first channel comprises a first through hole closer to the first conduit than the other through holes.
15. The substrate support according to clause 14, wherein the flow disruptor is connected to the first through hole.
16. The substrate support according to clause 15, wherein the first channel comprises a plurality of flow disruptors connected to corresponding through holes.
17. The substrate support according to clause 16, wherein the flow disruptor at the first through hole is configured to impede flow of fluid in the first direction more than the fluid disruptors disposed at through holes farther from the first conduit.
18. The substrate support according to clause 15, wherein the flow disruptors are configured to impede flow of fluid in the first direction less with increasing distance between the flow disruptor and the first conduit.
19. The substrate support according to any one of clauses 10 to 18, wherein the flow disruptor is configured to divert a flow of fluid along the first groove such that some fluid flowing through the first groove disrupts the flow of fluid in the first direction.
20. The substrate support according to clause 19, wherein the first groove is formed of a main groove and the flow disruptor comprises a subsidiary groove which branches off the main groove and re-joins the main groove.
21. The substrate support according to clause 20, wherein the subsidiary groove is configured such that, when fluid is flowing in the first direction, some fluid is diverted into the subsidiary groove and re-joins the main groove at an angle such that flow of fluid through the main groove in the first direction is impeded.
22. The substrate support according to clause 21, wherein the subsidiary groove is configured such that, when fluid is flowing in the second direction, less fluid is diverted through the subsidiary groove than when fluid is flowing in the first direction, and the fluid that flows through the subsidiary groove re-joins the main groove at an angle that promotes smooth flow of fluid through the main groove in the second direction.
23. The substrate support according to clause 19, wherein the first groove is formed of a main groove and the flow disruptor comprises a notch in the main groove.
24. The substrate support according to clause 23, wherein the notch is configured such that, when fluid is flowing in the first direction, some fluid is diverted into notch and is re-directed to impede flow of fluid through the main groove in the first direction.
25. The substrate support according to clause 24, wherein the notch is configured such that, when fluid is flowing in the second direction, less fluid is diverted into the notch than when fluid is flowing in the first direction, and fluid that flows into the notch is re-directed at an angle that promotes smooth flow of fluid through the main groove in the second direction.
26. The substrate support according to any preceding clause, wherein the second groove comprises a flow disruptor.
27. The substrate support according to clause 26, wherein the flow disruptor of the second groove is configured to impede flow in the first direction and allow flow in the second direction.
28. The substrate support according to any one of clauses 2 to 27, further comprising a first additional channel in fluid communication with the first conduit.
29. The substrate support according to clause 28, wherein the first additional channel is concentrically arranged with respect to the first channel.
30. The substrate support according to either of clauses 28 and 29, wherein the first additional channel comprises a flow disruptor.
31. The substrate support according to clause 30, wherein the flow disruptor of the first additional channel is configured to impede flow in the second direction and allow flow in the first direction.
32. The substrate support according to clause 31, wherein the substrate support is configured to apply a different force on the substrate via fluid flow through the first channel than the first additional channel.
33. The substrate support according to clause 26 or 27, further comprising a second additional channel in fluid communication with the second conduit.
34. The substrate support according to clause 33, wherein the second additional channel is concentrically arranged with respect to the second channel.
35. The substrate support according to clause 33 or 34, wherein the second additional channel comprises a flow disruptor.
36. The substrate support according to clause 35, wherein the flow disruptor of the second additional channel is configured to impede flow in the second direction and allow flow in the first direction.
37. The substrate support according to clause 36, wherein the substrate support is configured to apply a different force on the substrate via fluid flow through the second channel than the second additional channel.
38. A lithography apparatus comprising the substrate support according to any preceding clause.
39. A metrology system comprising the substrate support according to any of clauses 1-37.
40. A method of securing a substrate to a substrate support according to any of clauses 1 to 37, comprising
   providing a flow of fluid through the grooves in the first direction to create a negative pressure between the substrate and the substrate support.
41. A method of removing a substrate from a substrate support according to any of clauses 1 to 37, comprising
   providing a flow of fluid through the grooves in the second direction to reduce a negative pressure between the substrate and the substrate support.

## Claims

1. A substrate support configured to support a substrate, comprising a main body having:
a first side configured to support the substrate; and
a second side opposite to the first side;
wherein a plurality of grooves is formed in the main body;
wherein the plurality of grooves comprises a first groove and a second groove longer than the first groove;
wherein the first groove is configured to impede a flow of fluid through the first groove in a first direction and to allow the flow of fluid through the first groove in a second direction, opposing the first direction.

2. The substrate support according to claim 1, wherein the plurality of grooves forms a plurality of channels and a plurality of conduits, wherein the conduits are configured to enable fluid to be extracted from or provided to the corresponding channels,
wherein the first groove comprises a first channel and a first conduit, and the second groove comprises a second channel and a second conduit,
wherein the first conduit is in fluid communication with the first channel, and the second conduit is in fluid communication with the second channel.

3. The substrate support according to claim 2, wherein the first channel and the second channel each have a substantially arc shape.

4. The substrate support according to claim 3, wherein the first channel and the second channel extend in a circumferential direction of the substrate support.

5. The substrate support according to claim 4, wherein the first channel and the second channel are both disposed at the same radial distance from a centre of the substrate support.

6. The substrate support according to any of claims 2 to 5, wherein the second channel is longer than the first channel.

7. The substrate support according to any of claims 2 to 6, wherein the first conduit is the same length as the second conduit.

8. The substrate support according to any preceding claim, wherein the substrate support is configured such that the flow of fluid through the first groove in the first direction aids in attracting the substrate to the substrate support.

9. The substrate support according to claim 8, wherein the substrate support is configured such that the flow of fluid through the first groove in the second direction aids in reducing attraction between the substrate and the substrate support.

10. The substrate support according to any preceding claim, wherein the first groove comprises a flow disruptor configured to impede flow in the first direction and allow flow in the second direction.

11. The substrate support according to claim 10, wherein the first groove comprises a plurality of flow disruptors disposed at different positions along the first groove.

12. The substrate support according to claim 10 or 11, when dependent on claim 2, wherein each of the first channel and the second channel comprises at least one through hole, wherein the at least one through hole extends from the second side to the first side.

13. The substrate support according to claim 12, wherein the at least one through hole comprises a plurality of through holes.

14. The substrate support according to claim 13, wherein the plurality of through holes in the first channel comprises a first through hole closer to the first conduit than the other through holes.

15. The substrate support according to claim 14, wherein the flow disruptor is connected to the first through hole.

16. The substrate support according to claim 15, wherein the first channel comprises a plurality of flow disruptors connected to corresponding through holes.

17. The substrate support according to claim 16, wherein the flow disruptor at the first through hole is configured to impede flow of fluid in the first direction more than the fluid disruptors disposed at through holes farther from the first conduit.

18. The substrate support according to claim 15, wherein the flow disruptors are configured to impede flow of fluid in the first direction less with increasing distance between the flow disruptor and the first conduit.

19. The substrate support according to any one of claims 10 to 18, wherein the flow disruptor is configured to divert a flow of fluid along the first groove such that some fluid flowing through the first groove disrupts the flow of fluid in the first direction.

20. The substrate support according to claim 19, wherein the first groove is formed of a main groove and the flow disruptor comprises a subsidiary groove which branches off the main groove and re-joins the main groove.

21. The substrate support according to claim 20, wherein the subsidiary groove is configured such that, when fluid is flowing in the first direction, some fluid is diverted into the subsidiary groove and re-joins the main groove at an angle such that flow of fluid through the main groove in the first direction is impeded.

22. The substrate support according to claim 21, wherein the subsidiary groove is configured such that, when fluid is flowing in the second direction, less fluid is diverted through the subsidiary groove than when fluid is flowing in the first direction, and the fluid that flows through the subsidiary groove re-joins the main groove at an angle that promotes smooth flow of fluid through the main groove in the second direction.

23. The substrate support according to claim 19, wherein the first groove is formed of a main groove and the flow disruptor comprises a notch in the main groove.

24. The substrate support according to claim 23, wherein the notch is configured such that, when fluid is flowing in the first direction, some fluid is diverted into notch and is re-directed to impede flow of fluid through the main groove in the first direction.

25. The substrate support according to claim 24, wherein the notch is configured such that, when fluid is flowing in the second direction, less fluid is diverted into the notch than when fluid is flowing in the first direction, and fluid that flows into the notch is re-directed at an angle that promotes smooth flow of fluid through the main groove in the second direction.

26. The substrate support according to any preceding claim, wherein the second groove comprises a flow disruptor.

27. The substrate support according to claim 26, wherein the flow disruptor of the second groove is configured to impede flow in the first direction and allow flow in the second direction.

28. The substrate support according to any one of claims 2 to 27, further comprising a first additional channel in fluid communication with the first conduit.

29. The substrate support according to claim 28, wherein the first additional channel is concentrically arranged with respect to the first channel.

30. The substrate support according to either of claims 28 and 29, wherein the first additional channel comprises a flow disruptor.

31. The substrate support according to claim 30, wherein the flow disruptor of the first additional channel is configured to impede flow in the second direction and allow flow in the first direction.

32. The substrate support according to claim 31, wherein the substrate support is configured to apply a different force on the substrate via fluid flow through the first channel than the first additional channel.

33. The substrate support according to claim 26 or 27, further comprising a second additional channel in fluid communication with the second conduit.

34. The substrate support according to claim 33, wherein the second additional channel is concentrically arranged with respect to the second channel.

35. The substrate support according to claim 33 or 34, wherein the second additional channel comprises a flow disruptor.

36. The substrate support according to claim 35, wherein the flow disruptor of the second additional channel is configured to impede flow in the second direction and allow flow in the first direction.

37. The substrate support according to claim 36, wherein the substrate support is configured to apply a different force on the substrate via fluid flow through the second channel than the second additional channel.

38. A lithography apparatus comprising the substrate support according to any preceding claim.

39. A metrology system comprising the substrate support according to any of claims 1-37.

40. A method of securing a substrate to a substrate support according to any of claims 1 to 37, comprising
providing a flow of fluid through the grooves in the first direction to create a negative pressure between the substrate and the substrate support.

41. A method of removing a substrate from a substrate support according to any of claims 1 to 37, comprising
providing a flow of fluid through the grooves in the second direction to reduce a negative pressure between the substrate and the substrate support.
